# EUROPEAN PATENT APPLICATION

(11) **EP 3 073 519 A1**
(43) Date of publication of application: **28.09.2016**
(21) Application number: 15849814.7
(22) Date of filing: 25.11.2015
(51) Int. Cl.: H01L 21/316, H01L 21/203, H01L 51/56

(54) **METHOD FOR FORMING TIN OXIDE LAYER BY MEANS OF TIN METAL TARGET**

(30) Priority: 28.11.2014 KR 20140168296
(71) Applicant: RFtron Co., Ltd., Seoul 151-742 (KR)
(72) Inventor: CHAR, Kookrin, Seocho-gu, Seoul 06676 (KR); IHM, Jisoon, Seocho-gu, Seoul 06547 (KR)
(74) Representative: TBK
(86) International application number: PCT/KR2015/012713
(87) International publication number: WO 2016/085251

(57) **Abstract**

Provided is a method of forming a tin oxide layer using a tin metal target which forms the tin oxide layer on a glass substrate using the tin metal target. The present invention provides the method of forming a tin oxide layer using a tin metal target, which includes forming a tin oxide buffer layer (SnO₂) on the glass substrate by sputtering using the tin metal target and forming a tin oxide (SnO₂₋ₓ) semiconductor layer (0 < x ≤ 0.01) on the tin oxide buffer layer by sputtering using the tin metal target.

## Description

### [Technical Field]

The present invention relates to a method of forming a tin oxide layer, and more particularly, to a method of forming a tin oxide layer using a tin metal target which forms the tin oxide layer on a glass substrate using the tin metal target.

### [Background Art]

One of the current trends in information technology is an effort to achieve convergence of functions in an electronic device and a display device. Such convergence of combined functions of the electronic device and the display device is an electronic display device.

Further, in these days of an information-oriented society, the role of the electronic display device has become very important, and a variety of electronic display devices are being used widely across various industry fields. The field of electronic display has developed continually, and electronic display devices with new functions suitable for responding to diversified demands of the information-oriented society are being developed continuously.

Generally, the electronic display device refers to a device which visually transmits various types of information to a human being. That is, the electronic display device refers to an electronic device which converts electronic information signals output from various types of electronic devices into optical information signals that can be recognized by human vision, and may be referred to as a device serving the role of a bridge that connects electronic devices and human beings.

In the electronic display device, the case that an optical information signal is displayed by a phenomenon of light emission is referred to as an emission type display device, whereas the case that an optical information signal is displayed through an optical modulation by phenomena such as reflection, scattering, interference, or the like is referred to as a non-emission type display device.

The electronic display may include a cathode ray tube (CRT), a plasma display panel (PDP), an organic electro luminescence display (OELD), a liquid crystal display (LCD), an electro phoretic image display (EPID), a light emitting diode (LED), an organic light emitting diode (OLED), or the like.

Here, the CRT, as the display having the longest history, is being used for a television, a computer monitor, and the like, and has the largest market share from an economic perspective, but also has many demerits of a heavy weight, a large volume, high power consumption, and the like.

Recently, demands for a flat panel type display as the electronic display suitable for a new environment have been dramatically increased according to the trends of miniaturization, slimming, and lightening of electronic devices along with low voltage and low power trends in various electronics apparatuses based on a rapid advancement in semiconductor technology. Accordingly, flat panel type displays such as LCD, PDP, OELD, OLED, and the like are being developed.

The LCD is a display which displays desired images by adjusting a quantity of light which penetrates a transparent insulating substrate, in which each different electric potential is applied to a pixel electrode and a common electrode to adjust an intensity of an electric field being applied to a liquid crystal substance, and hence to change alignment of molecules of the liquid crystal substance which has an anisotropic dielectric constant and is injected between an upper transparent insulating substrate in which a common electrode, a color filter, a black matrix, and the like are formed, and a lower transparent insulating electrode in which a switching device, the pixel electrode, and the like are formed. In the LCD, a thin film transistor LCD (TFT LCD) which employs a TFT as a switching device is widely used.

Particularly, the OLED display is superior in its wide viewing angle, contrast ratio, and the like as compared to the LCD because the OLED device itself is the emission type, and the OLED display can be lightweight, slim and advantageous in terms of power consumption because a backlight is not necessary therein.

In addition, the OLED device is drivable by a direct-current at low voltage, is fast in response speed, is resistant to external impact, has a broad operating temperature range, and is particularly advantageous in terms of manufacturing cost.

Therefore, since the OLED device can be used as a pixel of a graphic display, a television image display, or a pixel of a surface light source, can be formed on a flexible transparent substrate such as a plastic, and has a good color quality, the OLED device is suitable for a next generation flat panel display.

An electronic display such as the OLED display requires transparency, high charge mobility and stability. Therefore, research into a transparent semiconductor, a transparent conductor and the manufacturing method which can satisfy the transparency and simultaneously perform functions as an electronic device are actively conducted. For instance, indium tin oxide (ITO) has been developed and used as such a transparent conductor, and ZnO and the like have been developed as the transparent semiconductor, but the application prospect is extremely limited due to low stability.

### [Prior Art Document]

### [Patent Document]

(Patent Document 1) Korea Patent Registration No. 10-1418304 (Date: July 4th, 2014)

### [Disclosure]

### [Technical Problem]

To resolve the above problems, research into employing a compound semiconductor based on tin oxide (SnO₂) (hereinafter, referred to as a tin oxide semiconductor (SnO₂₋ₓ)) as an electronic device for a display device is being conducted. The tix oxide semiconductor exists in various forms such as an amorphous structure, a polycrystalline structure, or a bi-directionally arranged crystalline structure.

The tin oxide semiconductor based on tin oxide may form the bi-directionally arranged crystalline structure on a specific substrate, for instance, such as sapphire substrate which has a crystal orientation, however, there is a problem that the tin oxide semiconductor may only form the amorphous structure or the polycrystalline structure on an amorphous glass substrate.

Because of this, there is a limit in applying the tin oxide semiconductor based on the bi-directionally arranged crystalline structure when using the tin oxide in an electronic display employing a glass substrate as a base substrate.

The present invention is directed to providing a method of forming a tin oxide layer using a tin metal target which is capable of easily forming the tin oxide layer on a glass substrate.

Another objective of the present invention is directed to providing a method of forming a tin oxide layer using a tin metal target which forms the tin oxide layer having suitable charge density and high charge mobility.

### [Technical Solution]

One aspect of the present invention provides a method of forming a tin oxide layer using a tin metal target, which includes forming a tin oxide (SnO₂) buffer layer on a glass substrate by sputtering using the tin metal target, and forming a tin oxide (SnO₂₋ₓ) semiconductor layer (0 < x ≤ 0.01) on the tin oxide buffer layer by sputtering using the tin metal target.

In the method of forming the tin oxide layer according to the present invention, in the forming of the tin oxide buffer layer, the sputtering may be performed at a pressure of 5 to 20 mTorr in a mixed atmosphere of oxygen gas and an inert gas.

In the method of forming the tin oxide layer according to the present invention, in the forming of the tin oxide semiconductor layer, the sputtering may be performed at a pressure of 0.1 to 3 mTorr in a mixed atmosphere of oxygen gas and an inert gas.

In the method of forming the tin oxide layer according to the present invention, a supply quantity of oxygen gas in the forming of the tin oxide buffer layer may be more than a supply quantity of oxygen gas in the forming of the tin oxide semiconductor layer.

In the method of forming the tin oxide layer according to the present invention, a composition ratio of oxygen in the tin oxide semiconductor layer may be in the range of 0.0000001 ≤ x ≤ 0.0001.

The method of forming the tin oxide layer according to the present invention may further include performing a heat treatment in the range of 300 °C to 450 °C in an oxygen atmosphere for 30 minutes to 90 minutes after forming the tin oxide semiconductor layer.

In the method of forming the tin oxide layer according to the present invention, the sputtering may be reactive sputtering.

Further, in the method of forming the tin oxide layer according to the present invention, the tin oxide semiconductor layer may be formed to be thinner than the tin oxide buffer layer.

### [Advantageous Effects]

According to the present invention, a tin oxide layer is formed by a sputtering method using a tin metal target, which facilitates the control of process conditions to form the tin oxide layer, and thereby the tin oxide layer can be easily formed on a glass substrate.

When forming the tin oxide layer on the glass substrate, since a tin oxide semiconductor layer is formed after forming a tin oxide buffer layer on the glass substrate, the tin oxide layer including the tin oxide semiconductor layer which has suitable charge density, high charge mobility, and excellent stability can be formed on the glass substrate.

In addition, since tin metal is used as the target, it is advantageous in that manufacturing cost to form the tin oxide layer on the glass substrate can be saved.

### [Description of Drawings]

FIG. 1 is a view illustrating a sputtering apparatus using a tin metal target according to an embodiment of the present invention.
FIG. 2 is a flowchart of a method for forming a tin oxide layer using the tin metal target according to the embodiment of the present invention.
FIGS. 3 to 5 are views illustrating each operation according to the method of forming a tin oxide layer shown in FIG. 2.
FIG. 6 is a cross sectional view illustrating a top-gate field effect transistor including the tin oxide layer formed by the forming method shown in FIG. 2.
FIG. 7 is a flowchart according to a method of manufacturing the top-gate field effect transistor shown in FIG. 6.
FIGS. 8 and 9 are graphs of current-voltage characteristics of the top-gate field effect transistor shown in FIG. 6.

### [Modes of the Invention]

In the following description, only the elements necessary for understanding embodiments of the present invention will be described, and it should be understood that description of the other elements will be omitted within the scope of not disturbing the sprit or the essentials of the present invention.

Those terminologies or words designated otherwise in this specification and the scope of claims in the following description are not limited or interpreted as a normal or lexical meaning. Based on the principle that an inventor may define terminologies to give a better understanding about the invention, those terminologies should be interpreted as a meaning and concept according to the aspects of the inventive concept. Therefore, since embodiments of the invention described in this specification and constitutions illustrated in the drawings are merely preferred embodiments and do not represent the entire inventive concept, it should be understood that various equivalents or modifications that may substitute these embodiments at the time of present application are included in the scope of the invention.

Hereinafter, embodiments of the present invention will be described in more detail with reference to the accompanying drawings.

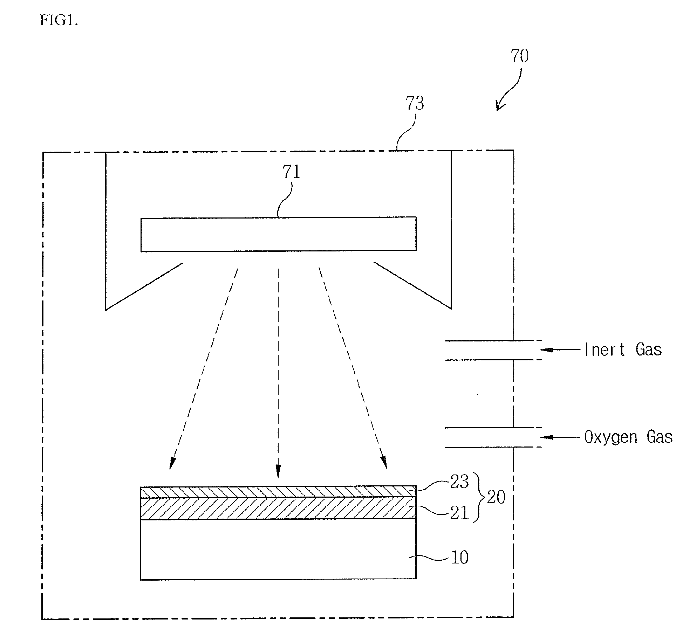

FIG. 1 is a view illustrating a sputtering apparatus using a tin metal target according to an embodiment of the present invention.

Referring to FIG. 1, a sputtering apparatus 70 supplies an inert gas and oxygen gas into a chamber 73 in which a tin metal target 71 and a glass substrate 10 are located to form a tin oxide layer 20 on the glass substrate 10. The tin oxide layer 20 includes a tin oxide buffer layer 21 formed on the glass substrate 10 and a tin oxide semiconductor layer 23 formed on the tin oxide buffer layer 21.

The sputtering to form the tin oxide layer 20 is performed in an atmosphere in which the inert gas and oxygen gas are supplied, and sequentially forms the tin oxide buffer layer 21 and the tin oxide semiconductor layer 23 by adjusting a supply quantity of oxygen gas regulated by pressure.

When supplying oxygen gas and the inert gas, the inert gas may be supplied toward a part close to the tin metal target 71 and the oxygen gas may be supplied toward a part close to the glass substrate so that the tin oxide layer is easily formed on the glass substrate.

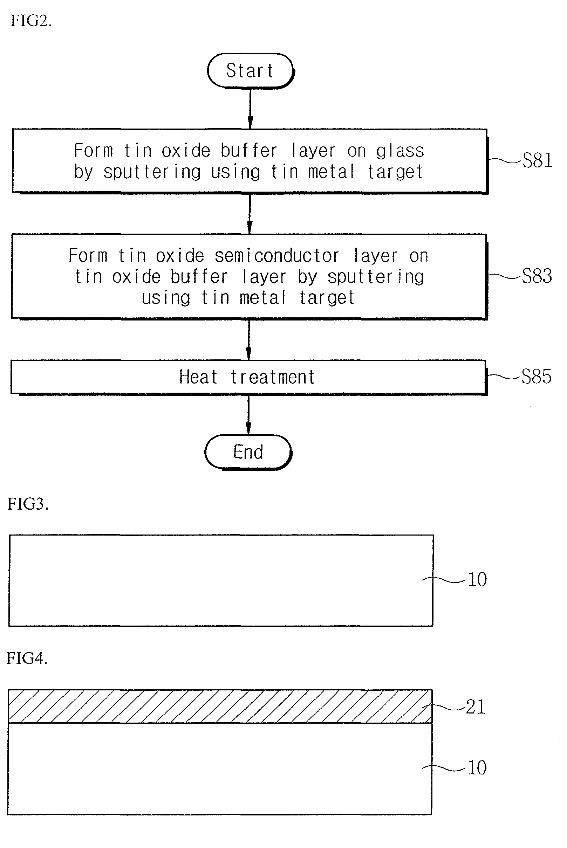

Descriptions below are with reference to FIGS. 1 to 5 and refer to a method of forming the tin oxide layer 20 using the sputtering apparatus 70 which uses the tin metal target 71 according to the embodiment of the present invention. Here, FIG. 2 is a flowchart of the method for forming the tin oxide layer 20 using the tin metal target 71 according to the embodiment of the present invention. In addition, FIGS. 3 to 5 are views illustrating each step according to the method of forming the tin oxide layer 20 shown in FIG. 2.

First, the glass substrate 10 on which the tin oxide layer 20 is to be formed is provided as illustrated in FIG. 3.

Then, the tin oxide buffer layer 21 is formed on the glass substrate 10 in operation S81 as shown in FIG. 4. The tin oxide buffer layer 21 is formed by sputtering using the tin metal target 71. The tin oxide buffer layer 21 may have a composition of SnO₂. A reactive sputtering may be employed as the sputtering method.

For instance, the tin oxide buffer layer 21 may be formed by reactive sputtering using the tin metal target 71 at a pressure of 5 to 20 mTorr in a mixed atmosphere of oxygen gas and an inert gas. For example, a supply ratio of the oxygen gas to the inert gas may be 6:4 but is not limited thereto. As the inert gas, argon gas or nitrogen gas may be used. A temperature of the glass substrate 10 may be in the range of room temperature to 600 °C.

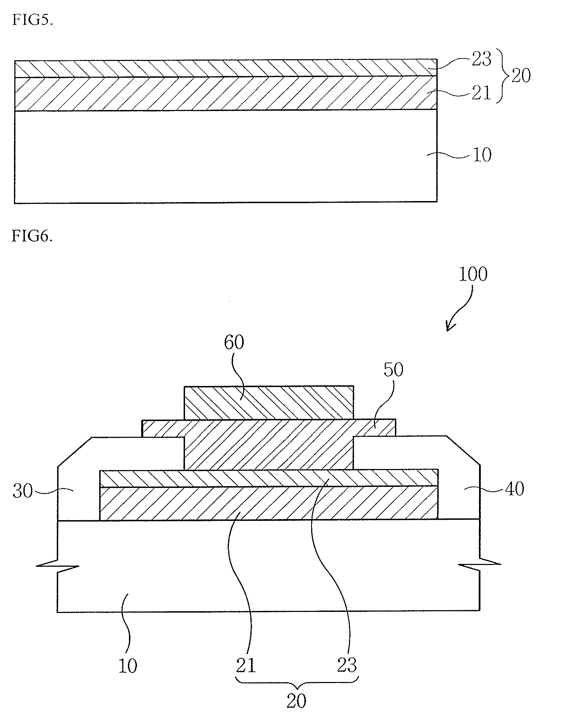

Then, as illustrated in FIG. 5, the tin oxide semiconductor layer 23 is formed on the tin oxide buffer layer 21 in operation S83. The tin oxide semiconductor layer 23 is formed by sputtering using the tin metal target 71. The reactive sputtering may be employed as the sputtering method.

The tin oxide semiconductor layer 23 may have a composition of SnO₂₋ₓ (0 < x ≤ 0.01).

Here, the reason that oxygen has the composition ratio of 0 < x ≤ 0.01 is to allow the tin oxide semiconductor layer 23 to have semiconductor properties. That is, in the case when x is 0, for example, the SnO₂ reveals properties of an insulator, thus x should be more than 0. When x is more than 0.01 by being doped with oxygen, the SnO₂ reveals metallicity, thus x should have the composition ratio equal to or less than 0.01. Therefore, the composition ratio of oxygen is in the range of 0 < x ≤ 0.01 so that the tin oxide semiconductor layer 23 according to the embodiment of the present invention has semiconductor properties.

For example, the tin oxide semiconductor layer 23 may be formed by reactive sputtering using the tin metal target 71 at the pressure range of 0.1 to 3 mTorr in a mixed atmosphere of oxygen gas and an inert gas. For instance, a supply ratio of the oxygen gas to the inert gas may be 6:4 but is not limited thereto. Argon gas or nitrogen gas may be used as the inert gas. The temperature range of the glass substrate 10 may be in the range from room temperature to 600 °C. Here, the composition ratio of oxygen in the tin oxide semiconductor layer 23 may be in the range of 0.0000001 ≤ x ≤ 0.0001.

Operations S81 and S83 are performed consecutively, and the tin oxide buffer layer 21 and the tin oxide semiconductor layer 23 are formed sequentially by adjusting the supply quantity of oxygen gas regulated by pressure while maintaining a constant supply ratio of the oxygen gas to the inert gas. Here, the supply quantity of the oxygen gas in the formation of the tin oxide buffer layer 21 is more than the supply quantity of the oxygen gas in the formation of the tin oxide semiconductor layer 23.

In addition, in operation S85, the tin oxide layer 20 which includes the tin oxide buffer layer 21 and the tin oxide semiconductor layer 23 is formed by a heat treatment on the tin oxide semiconductor layer 23 and the tin oxide buffer layer 21 formed on the glass substrate 10. Here, the heat treatment may be performed in the range of 300 °C to 450 °C in an oxygen gas atmosphere for 30 to 90 minutes.

Here, the tin oxide semiconductor layer 23 is formed to be thinner than the tin oxide buffer layer 21. For instance, the tin oxide buffer layer 21 is formed in the thickness range of 50 nm to 300 nm, and the tin oxide semiconductor layer 23 may be formed in the thickness range of 5 nm to 20 nm

According to the method of forming the tin oxide layer 20 according to the embodiment of the present invention, the tin oxide layer 20 is formed by a sputtering method using the tin metal target which facilitates the control of process conditions to form the tin oxide layer 20, and thereby the tin oxide layer 20 can be easily formed on the glass substrate.

In addition, when forming the tin oxide layer 20 on the glass substrate 10, since the tin oxide semiconductor layer 23 is formed after forming the tin oxide buffer layer 21 on the glass substrate 10, the tin oxide layer 20 including the tin oxide semiconductor layer 23 having suitable charge density, high charge mobility, and excellent stability may be formed on the glass substrate 10.

In addition, since the tin metal target 71 is used as a target, it is advantageous in that manufacturing cost to form the tin oxide layer 20 on the glass substrate 10 can be saved.

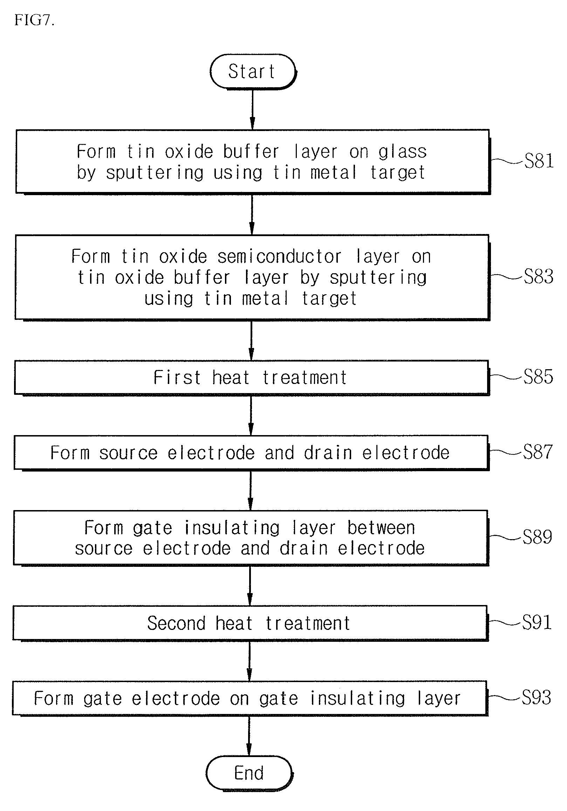

To find characteristics of the tin oxide layer 20 formed by the forming method according to the embodiment of the present invention, a top-gate field effect transistor 100 according to an embodiment including the tin oxide layer 20 was manufactured as illustrated in FIGS. 6 and 7, and characteristics of the top-gate field effect transistor 100 were tested.

FIG. 6 is a cross sectional view illustrating the top-gate field effect transistor 100 according to the embodiment including the tin oxide layer 20 formed by the forming method shown in FIG. 2.

Referring to FIG. 6, the top-gate field effect transistor 100 according to the embodiment includes a glass substrate 10, the tin oxide layer 20 having the tin oxide buffer layer 21 and the tin oxide semiconductor layer 23, a source electrode 30, a drain electrode 40, a gate insulating layer 50, and a gate electrode 60.

The tin oxide layer 20 is formed on the glass substrate 10. That is, the tin oxide layer 20 includes the tin oxide buffer layer 21 formed on the glass substrate 10, and the tin oxide semiconductor layer 23 formed on the tin oxide buffer layer 21.

The source electrode 30 and the drain electrode 40 are formed at opposite sides of the tin oxide layer 20 and are formed to cover opposing edge portions of the tin oxide layer 20. For example, indium tin oxide (ITO), indium zinc oxide (IZO), indium tin zinc oxide (ITZO), Al dopedZinc oxide (AZO), or gallium zinc oxide (GZO), may be used as the source electrode 30 and the drain electrode 40, but the source electrode 30 and the drain electrode 40 are not limited thereto.

The gate insulating layer 50 is formed to cover the tin oxide layer 20 exposed between the source electrode 30 and the drain electrode 40, and a portion of the source electrode 30 and the drain electrode 40. HfO₂, a silicon dioxide (SiOₓ), alumina (Al₂O₃), TiOₓ, sapphire, polyvinyl alcohol, polyvinyl acetate, polyimide, parylene, polyvinyl phenol (PVP), acryl, fluoropolymer, polymethyl methacrylate, or the like may be used as the gate insulating layer 50, but the gate insulating layer 50 is not limited thereto.

In addition, the gate electrode 60 is formed on the gate insulating layer 50, and is formed above the tin oxide layer 20 exposed between the source electrode 30 and the drain electrode 40. ITO, IZO, ITZO, AZO, GZO or the like may be used as the gate electrode 60, but the gate electrode 60 is not limited thereto.

Descriptions below are with reference to FIGS. 6 and 7 and refer to a method of manufacturing the top-gate field effect transistor 100 according to the embodiment.

First, the glass substrate 10 is provided.

Then, in operation S81, the tin oxide buffer layer 21 is formed on the glass substrate 10. The tin oxide buffer layer 21 is formed by reactive sputtering using the tin metal target 71. The tin oxide buffer layer 21 has a composition of SnO₂. That is, the tin oxide buffer layer 21 is formed to have a thickness of 100 nm by reactive sputtering using the tin metal target at a pressure of 15 mTorr, in an atmosphere of oxygen gas and argon gas, and at room temperature. Here, the composition ratio of the oxygen gas to the argon gas may be 6:4.

Then, in operation 83, the tin oxide semiconductor layer 23 is formed on the tin oxide buffer layer 21. The tin oxide semiconductor layer 23 is formed by reactive sputtering using the tin metal target. The tin oxide semiconductor layer 23 has a composition of SnO₂₋ₓ.

That is, the tin oxide semiconductor layer 23 is formed to have a thickness of 10 nm by reactive sputtering using the tin metal target at a pressure of 2 mTorr and in a mixed atmosphere of oxygen gas and argon gas at room temperature. Here, the composition ratio of the oxygen gas to the argon gas may be 6:4.

Operations S81 and S83 are performed consecutively, and the tin oxide buffer layer 21 and the tin oxide semiconductor layer 23 are formed sequentially by regulating pressure while maintaining the supply ratio of the oxygen gas to the argon gas as 6:4.

Here, the supply quantity of oxygen gas in the formation of the tin oxide buffer layer 21 is more than the supply quantity of oxygen gas in the formation of the tin oxide semiconductor layer 23. That is, when forming the tin oxide buffer layer 21, in the case of a pressure of 15 mTorr, a pressure ratio of the argon gas to the oxygen gas is 6 mTorr : 9 mTorr. When forming the tin oxide semiconductor layer 23, in the case of a pressure of 2 mTorr, the pressure ratio of the argon gas to the oxygen gas is 0.8 mTorr : 1.2 mTorr.

Then, in operation S85, the tin oxide layer 20 is formed by a first heat treatment on the tin oxide semiconductor layer 23 and the tin oxide buffer layer 21 formed on the glass substrate 10. The first heat treatment is performed at 400 °C in an oxygen gas atmosphere for 60 minutes.

After the first heat treatment according to operation S85, a patterning is performed on the tin oxide layer 20.

Then, in operation S87, the source electrode 30 and the drain electrode 40 are formed at opposite sides of the tin oxide layer 20 to cover an edge portion of the tin oxide layer 20. The source electrode 30 and the drain electrode 40 are formed to have a thickness of 50 nm using ITO.

Then, in operation S89, the gate insulating layer 50 is formed between the source electrode 30 and the drain electrode 40. The gate insulating layer 50 is formed to cover the tin oxide layer 20 exposed between the source electrode 30 and the drain electrode 40, and a portion of the source electrode 30 and the drain electrode 40. The gate insulating layer 50 is formed to have a thickness of 80 nm using HeO2. Here, the reason of using HfO₂ for the gate insulating layer 50 is due to better depletion properties of HfO₂ as compared to Al₂O₃.

Then, in operation S91, a second heat treatment is performed at 400 °C in an oxygen gas atmosphere for 120 minutes.

In addition, in operation S93, the gate electrode 60 is formed on the gate insulating layer 50. Here, the gate electrode 60 is formed above the tin oxide layer 20 exposed between the source electrode 30 and the drain electrode 40. The gate electrode 60 is formed to have a thickness of 50 nm using the ITO.

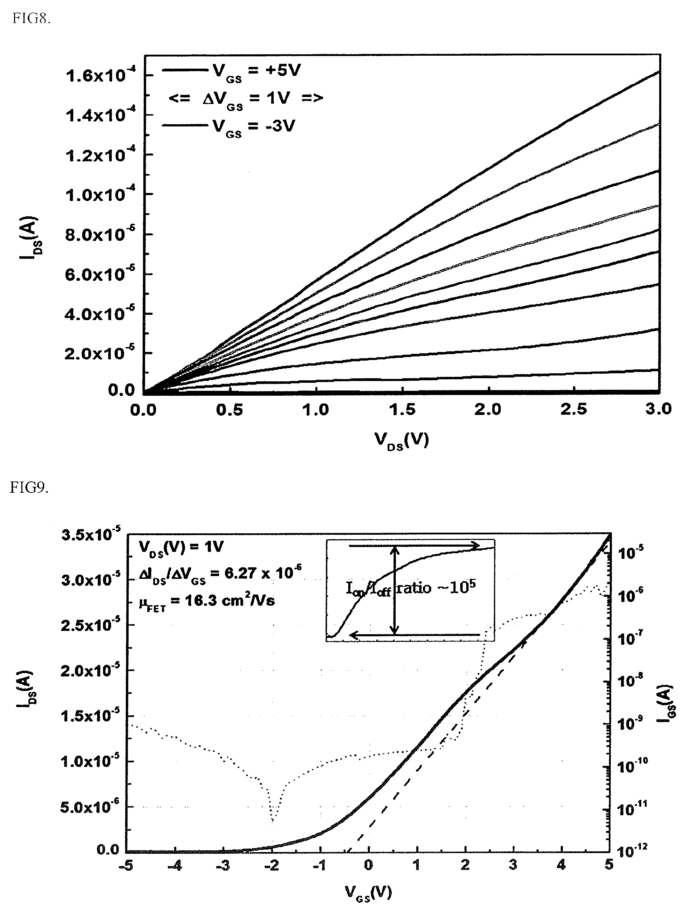

FIGS. 8 and 9 are current-voltage characteristics of the top-gate field effect transistor 100 manufactured according to the above-described embodiment. Here, FIGS. 8 and 9 are current-voltage characteristics graphs of the top-gate field effect transistor shown in FIG. 6.

Referring to FIG. 8, according to the embodiment of the top-gate field effect transistor, a top-gate field effect transistor having the tin oxide layer 20 which featured 15.3 cm²/Vs of charge mobility at a pressure condition of 2 mTorr was manufactured.

It may be verified through FIG. 8 that the top-gate field effect transistor according to the embodiment effectively performs an operation of accumulating or losing electric charge according to an electric field.

Referring to FIG. 9, I_{DS} - V_{GS} of the top-gate field effect transistor according to the embodiment were measured below. That is, a result of measuring in the voltage range of the gate electrode from -5 V to 5 V and setting V_{DS} to 1 V, the charge mobility was calculated as 16.3 cm²/Vs, which was the same level as the charge mobility of 15.3 cm²/Vs of the thin film of the tin oxide layer formed on the glass.

It may be verified that the top-gate field effect transistor including the tin oxide layer using the tin metal target has good charge mobility.

Meanwhile, the embodiments disclosed in this specification and the drawings are merely for providing a specific example for better understanding, but are not for limiting the scope of the present invention. Besides the embodiments disclosed here, it should be obvious to those skilled in the art that various changes and modifications may be made in these embodiments based on the technical concept and sprit of the invention.

### [Reference Numerals]

10 : GLASS SUBSTRATE
20 : TIN OXIDE LAYER
21 : TIN OXIDE BUFFER LAYER
23 : TIN OXIDE SEMICONDUCTOR LAYER
30 : SOURCE ELECTRODE
40 : DRAIN ELECTRODE
50 : GATE INSULATING LAYER
60 : GATE ELECTRODE
70 : SPUTTERING APPARATUS
71 : TIN METAL TARGET
100 : TOP-GATE FIELD EFFECT TRANSISTOR

## Claims

1. A method of forming a tin oxide layer using a tin metal target, comprising:
forming a tin oxide (SnO₂) buffer layer on a glass substrate by a first sputtering using the tin metal target; and
forming a tin oxide (SnO₂₋ₓ) semiconductor layer (0 < x ≤ 0.01) on the tin oxide buffer layer by a second sputtering using the tin metal target.

2. The method of claim 1, wherein in the forming of the tin oxide buffer layer, the first sputtering is performed at a pressure of 5 to 20 mTorr in a mixed atmosphere of oxygen gas and an inert gas.

3. The method of claim 2, wherein in the forming of the tin oxide semiconductor layer, the second sputtering is performed at a pressure of 0.1 to 3 mTorr in a mixed atmosphere of oxygen gas and an inert gas.

4. The method of claim 3, wherein a supply quantity of oxygen gas in the forming the tin oxide buffer layer is more than a supply quantity of oxygen gas in the forming of the tin oxide semiconductor layer.

5. The method of claim 3, wherein a composition ratio of oxygen in the tin oxide semiconductor layer is in the range of 0.0000001 ≤ x ≤ 0.0001.

6. The method of claim 3, further comprising:
performing a heat treatment in the range of 300 °C to 450 °C in an oxygen atmosphere for 30 minutes to 90 minutes after forming the tin oxide semiconductor layer.

7. The method of claim 1, wherein the first and the second sputtering are reactive sputtering.

8. The method of claim 1, wherein the tin oxide semiconductor layer is formed to be thinner than the tin oxide buffer layer.
